# EUROPEAN PATENT SPECIFICATION

(11) **EP 1 034 886 B1**
(45) Date of publication and mention of the grant of the patent: **15.06.2005**
(21) Application number: 00104556.6
(22) Date of filing: 13.03.2000
(51) Int. Cl.: B24B 37/04, B24B 31/00

(54) **Polishing apparatus including attitude controller for dressing apparatus**
Poliereinrichtung enthaltend eine Einstellkontrolle für eine Abziehvorrichtung
Appareils de polissage comprenant un contrôleur d'attitude pour un dispositif de repassage

(30) Priority: 11.03.1999 JP 6571099
(43) Date of publication of application: 13.09.2000
(73) Proprietor: EBARA CORPORATION, Ohta-ku Tokyo 144 (JP)
(72) Inventor: Satoh, Ichiju, Fujisawa-shi, Kanagawa-ken (JP); Kimura, Norio, Fujisawa-shi, Kanagawa-ken (JP)
(74) Representative: Wagner, Karl H., Dipl.-Ing.

(56) References cited:
- EP-A1- 0 589 433
- WO-A1-99/50024
- GB-A- 2 287 422
- JP-A- 10 058 308
- US-A- 5 951 368

## Description

The present invention relates to a polishing apparatus for polishing a semiconductor wafer surface, particularly a semiconductor wafer with a device pattern formed thereon, by engaging the semiconductor wafer surface with a polishing cloth to effect planarization of the wafer surface. More particularly, the present invention relates to a dressing apparatus for dressing a polishing cloth bonded to a turntable of such a polishing apparatus.

With recent rapid progress in technology for fabricating high-integration semiconductor devices, circuit wiring patterns have been becoming increasingly fine, with spaces between wiring patterns also decreasing. As wiring spacing decreases to less than 0.5 microns, the depth of focus in circuit pattern formation in photolithography and the like becomes shallower. Accordingly, surfaces of semiconductor wafers on which circuit pattern images are to be formed by a stepper are required to be polished by a polishing apparatus to have an exceptionally high degree of surface flatness or planarization. As one method for such a planarization, for example, a chemical/mechanical polishing (CMP) method has been used, in which mechanical polishing is carried out while a polishing solution having a predetermined chemical composition is supplied.

In a conventional polishing apparatus for polishing a semiconductor wafer surface, in particular, a semiconductor wafer with a device pattern formed thereon to effect planarization thereof, a nonwoven fabric is used as a polishing cloth bonded to the upper surface of a turntable.

However, the degree of integration of ICs and LSIs has been increasing in recent years. Consequently, it is demanded that a polished surface be planarized to an even higher degree. To meet such a demand, a relatively rigid polishing cloth, for example, a polishing cloth made of urethane foam has come into use.

Polishing is carried out by rotating a turntable which has a polishing cloth affixed thereto, with the polishing cloth being kept in contact with a semiconductor wafer during rotation of the turntable. During the polishing operation, however, abrasive particles (grains) and substances removed from the wafer surface during polishing tend to adhere to the polishing cloth, resulting in a deterioration of the quality of the polishing cloth, and a concomitant deleterious effect on the polishing operation. Consequently, when polishing of semiconductor wafers is repeatedly carried out using the same polishing cloth, the quality of polishing is adversely affected, and there is a danger that a wafer surface will not be evenly polished. To avoid this problem, conditioning known as "dressing" is carried out to normalize the surface of the polishing cloth before, after or during polishing of a semiconductor wafer.

When dressing a rigid polishing cloth made of a urethane foam or the like, a dresser tool comprising a material of high hardness such as diamond is generally employed. The polishing cloth is thus subject to grinding each time it is dressed. A polishing cloth made of urethane foam, for example, IC1000 (manufactured by Rodel Nitta Company) is designed to have tolerances of 1 micrometer or less each time it is dressed.

It is imperative that a polishing cloth have a flat polishing surface, in order for it to be able to polish an object uniformly to a high degree of planarity. Variations in orientation or attitude of a dresser tool resulting in non-uniformity of pressure during dressing result in a polishing cloth which does not have the requisite degree of flatness, and which is thus unable to polish a wafer to a required degree of planarity.

In the dresser tool described above, a decrease in the amount of pressure applied to a polishing cloth during dressing results in a decrease in the amount of grinding to which the polishing cloth is subject. This translates into an increase in the working life of the polishing cloth. However, such a decrease in the amount of pressure applied by a dresser to a polishing cloth during dressing has a negative influence on the stability of the dresser, whereby dressing may produce an uneven or undulating surface on a polishing cloth.

With respect to a polishing apparatus, attention is drawn to JP10-058308, which discloses a polishing apparatus which is provided with an attitude controller for controlling an attitude or orientation of a top ring for holding and pressing a workpiece to be polished against a polishing cloth. The orientation of the top ring being controlled by means of an electromagnetic force.

Further, GB 2 287 422 discloses an apparatus for surface treatment of a polishing cloth having a surface treatment tool which is to be pressed against a polishing cloth in a rotating manner, while the polishing cloth itself is also rotated. Said surface treatment tool and said polishing cloth being rotated about spaced parallel axes.

In view of the above-described circumstances, an object of the present invention is to provide an apparatus for dressing a polishing surface of a turntable wherein control of the attitude or orientation of a dresser tool thereof is effected by utilizing electromagnetic forces, whereby the polishing surface of a turntable can be polished to a requisite high degree of flatness.

Another object of the present invention is to provide a polishing apparatus provided with such a dressing apparatus.

To attain the above-described objects, the present invention provides a dressing apparatus for dressing a polishing surface of a turntable that comes into sliding contact with an object to be polished. The dressing apparatus includes a dresser body which comes into contact with the polishing surface to effect dressing. A pressing device presses the dresser body against the polishing surface of the turntable. An attitude controller controls the attitude or orientation of the dresser body by utilizing an electromagnetic force.

In addition, the present invention provides a polishing apparatus which includes a turntable having a polishing surface that comes into sliding contact with an object to be polished, and a dressing apparatus for dressing the polishing surface. The dressing apparatus includes a dresser body for dressing the polishing surface by coming into contact with the polishing surface. A pressing device presses the dresser body against the polishing surface of the turntable. An attitude controller controls the attitude or orientation of the dresser body by utilizing an electromagnetic force.

According to the present invention, the attitude or orientation of a dresser is controlled by utilizing an electromagnetic force, thereby allowing dressing to be carried out while maintaining an optimum distribution of surface pressure on the polishing surface applied by the dresser. Accordingly, it is possible to obtain a polishing surface having a high degree of flatness.

The above and other objects, features and advantages of the present invention will become more apparent from the following description of the preferred embodiments thereof, taken in conjunction with the accompanying drawings.
Fig. 1 is a vertical sectional view showing the general arrangement of a first embodiment of the polishing apparatus according to the present invention.
Fig. 2 is a fragmentary sectional view showing an essential part of the dressing apparatus according to the present invention.
Fig. 3 is a sectional view taken along the line III-III in Fig. 2.
Fig. 4 is a sectional view taken along the line IV-IV in Fig. 3.
Fig. 5 is a block diagram showing the functional arrangement of a control part for controlling an attitude controller for a dresser.
Fig. 6 is a diagram illustrating the relationship between the tilt α of the dresser with respect to an X-axis and the tilt β of the dresser with respect to a Y-axis.
Figs. 7(a) - (c) show details of the structure of a dresser body, in which: Fig. 7(a) is a bottom view; Fig. 7(b) is a sectional view taken along the line a-a in Fig. 7(a); and Fig. 7(c) is an enlarged view of a portion b shown in Fig. 7(b).
Fig. 8 is a vertical sectional view showing the general arrangement of a second embodiment of the polishing apparatus according to the present invention.
Fig. 9 is a sectional view taken along the line IX-IX in Fig. 8.
Fig. 10 is a sectional view taken along the line X-X in Fig. 9.
Fig. 11 is a block diagram showing the functional arrangement of a control part for controlling an attitude controller for a turntable.

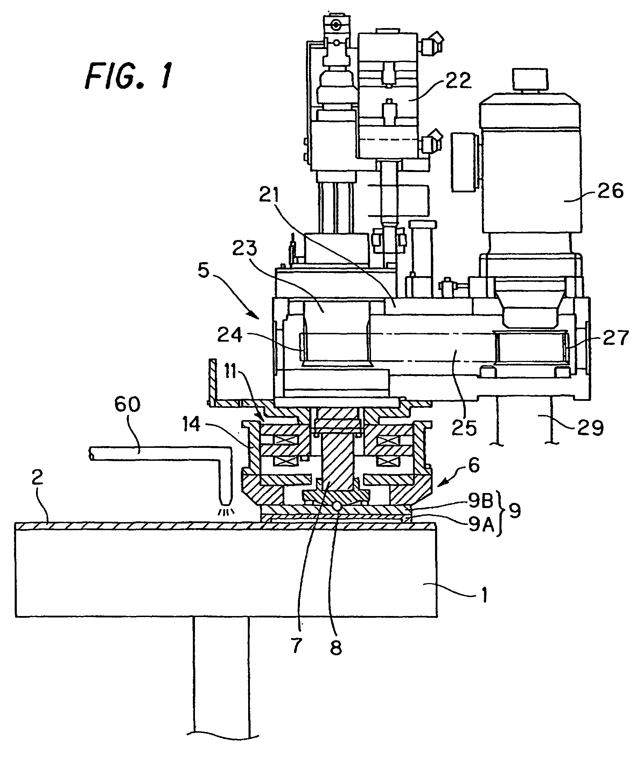

Embodiments of the dressing apparatus and polishing apparatus according to the present invention will be described below in detail with reference to Figs. 1 to 11.

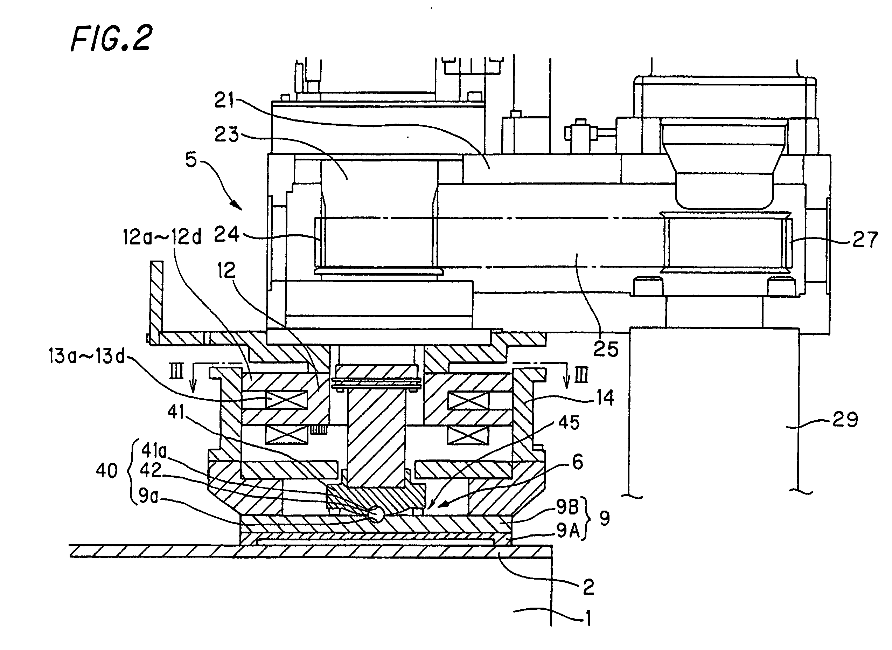

Fig. 1 is a vertical sectional view showing the general arrangement of a first embodiment of the polishing apparatus according to the present invention, and Fig. 2 is a fragmentary sectional view showing an essential part of the dressing apparatus according to the present invention.

As shown in Figs. 1 and 2, the polishing apparatus includes a turntable 1 having a polishing cloth 2 bonded to the upper surface thereof, and a dressing apparatus 5 for dressing the polishing cloth 2. The dressing apparatus 5 includes a dresser 6 for dressing the polishing cloth 2, and a dresser driving shaft 7 for supporting the dresser 6 and applying a pressing force and rotational driving force to the dresser 6. The dressing apparatus 5 further includes a universal coupling 8 for transmitting pressing force from the dresser driving shaft 7 to the dresser 6 while allowing these members to tilt relative to each other, and an attitude controller 11 for controlling the attitude or orientation of the dresser 6. A dressing liquid supply nozzle 60 is provided above the turntable 1 to supply a dressing liquid onto the polishing cloth 2 on the turntable 1. The upper surface of the polishing cloth 2 constitutes a polishing surface that comes into sliding contact with a surface of a semiconductor wafer to be polished.

As shown in Fig. 2, the dresser 6 includes a dresser body 9 comprising a dressing plate 9A, which constitutes a lower part of the dresser body 9, and a mounting plate 9B, which constitutes an upper part of the dresser body 9 connected to the dresser drive shaft 7. The dresser 6 further includes a diamond ring 10 electrodeposited on a projecting portion of the bottom surface of the dresser body 9.

As shown in Fig. 1, the dresser driving shaft 7 is coupled to a dresser air cylinder 22 secured to a dresser head 21. The dresser air cylinder 22 causes the dresser driving shaft 7 to move vertically, causing the diamond electrodeposited ring 10 on the lower end surface of the dresser 6 to be pressed against the turntable 1.

The dresser driving shaft 7 is coupled to a rotating cylinder 23 through a key (not shown). The rotating cylinder 23 has a timing pulley 24 on an outer peripheral portion thereof. The timing pulley 24 is connected through a timing belt 25 to a timing pulley 27 provided on a dresser motor 26 secured to the dresser head 21. Accordingly, the dresser motor 26 drivingly rotates the rotating cylinder 23 and the dresser driving shaft 7 through the timing pulley 27, the timing belt 25 and the timing pulley 24, thereby drivingly rotating the dresser 6. The dresser head 21 is supported by a dresser head shaft 29 fixedly supported on a frame.

The universal coupling 8, which transmits a pressing force from the dresser driving shaft 7 to the dresser 6 while allowing these members to tilt relative to each other, has a spherical bearing mechanism 40 that allows the dresser 6 and the dresser driving shaft 7 to tilt relative to each other. The universal coupling 8 further has a rotation transmitting mechanism 45 for transmitting the rotation of the dresser driving shaft 7 to the dresser body 9. The spherical bearing mechanism 40 includes a spherical recess 41a formed in the center of the lower surface of a driving flange 41 secured to the lower end of the dresser driving shaft 7. The spherical bearing mechanism 40 further includes a spherical recess 9a formed in the center of the upper surface of the mounting plate 9B, and a ball bearing 42 interposed between the two recesses 41a and 9a. The ball bearing 42 is made of a material of high hardness, such as a ceramic.

The rotation transmitting mechanism 45 includes a driving pin (not shown) secured to the driving flange 41 and a driven pin (not shown) secured to the mounting plate 9B. The driven pin and the driving pin are vertically movable relative to each other. Therefore, even when the dresser body 9 tilts, the driven pin and the driving pin are kept in engagement with each other, with a point of contact shifting between them. Thus, the rotation transmitting mechanism 45 transmits the rotational torque of the dresser driving shaft 7 to the dresser body 9 in a reliable and stable fashion.

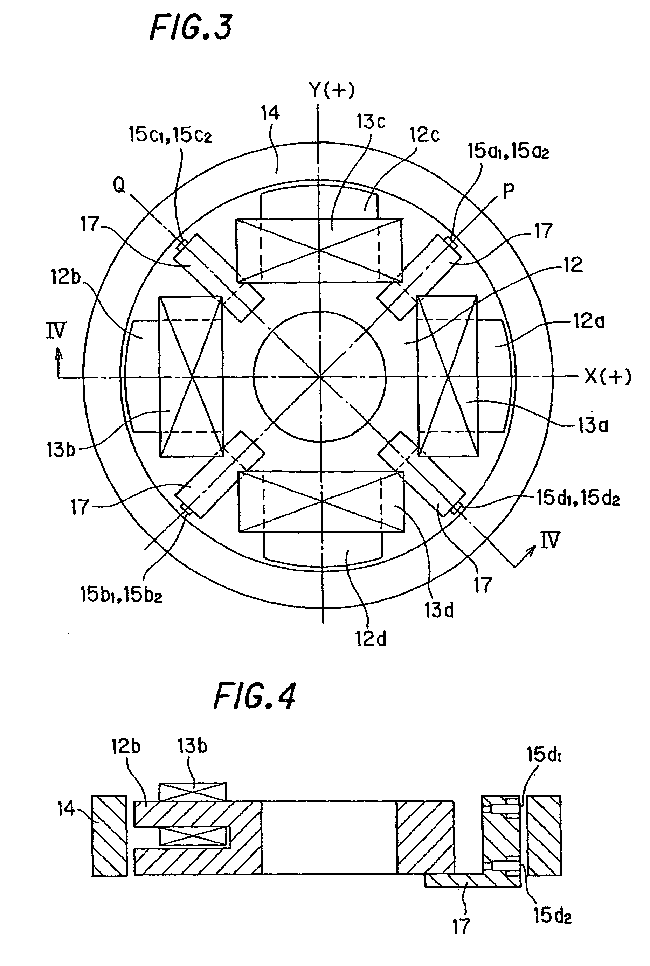

Next, the attitude controller 11 for controlling the attitude of the dresser 6 will be described with reference to Figs. 2 to 6. Fig. 2 is a fragmentary sectional view showing an essential part of the dressing apparatus, as stated above. Fig. 3 is a view as seen in the direction of the arrow III-III in Fig. 2, and Fig. 4 is a sectional view taken along the line IV-IV in Fig. 3.

As shown in Figs. 2 and 3, the attitude controller 11 includes an electromagnetic core 12 secured to the dresser head 21. Four magnetic poles 12a, 12b, 12c and 12d project radially outward from the electromagnetic core 12. Four electromagnetic coils 13a, 13b, 13c and 13d are wound on the magnetic poles 12a to 12d, respectively. The attitude controller 11 further includes a cylindrical armature 14 facing the magnetic poles 12a to 12d across a gap. The armature 14 is secured to the dresser body 9.

As shown in Fig. 4, the magnetic poles 12a to 12d each have a U-shaped sectional configuration having a 90-degree rotation. The upper horizontally projecting portions of the magnetic poles 12a to 12d are wound with the electromagnetic coils 13a to 13d, respectively. The magnetic poles 12a to 12d and the armature 14 are formed from a magnetic material, e.g. a permalloy. As shown in Fig. 3, the electromagnetic coil 13a is placed at a position in positive alignment with the X-axis. The electromagnetic coil 13b is placed at a position in negative alignment with the X-axis. The electromagnetic coil 13c is placed at a position in positive alignment with the Y-axis. The electromagnetic coil 13d is placed at a position in negative alignment with the Y-axis. Four pairs of displacement sensors 15a₁, 15a₂; 15b₁, 15b₂; 15c₁, 15c₂; and 15d₁, 15d₂ are placed on two axes P and Q tilted at an angle of 45 degrees with respect to the X- and Y-axes. Each pair of displacement sensors consists of upper and lower displacement sensors. Each displacement sensor pair is held by a sensor holder 17.

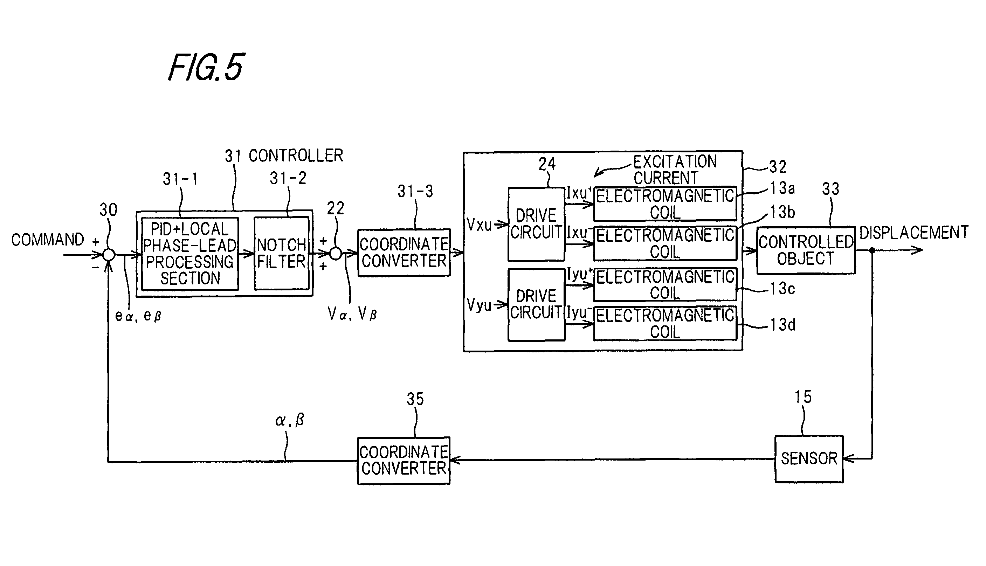

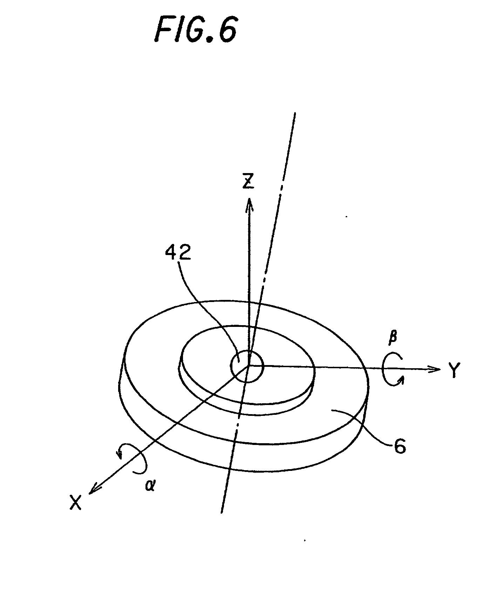

Fig. 5 is a block diagram showing the functional arrangement of a control part for controlling the attitude controller 11. As shown in the figure, the control part has a subtracter 30 and a controller 31. The subtracter 30 is supplied with desired values for the attitude of the dresser 6, and values α and β of displacement of a controlled object (dresser 6) that are detected by sensors 15 (displacement sensors 15a₁, 15a₂; 15b₁, 15b₂; 15c₁, 15c₂; and 15d₁, 15d₂) and converted in a coordinate converter 35. Differences between the desired values and the displacement values α and β derived from the subtracter 30 are input to the controller 31 as error signals eα and eβ. As shown in Fig. 6, α and β indicate a tilt with respect to an X-axis and a tilt with respect to a Y-axis, respectively. The X-axis and the Y-axis lie along a horizontal plane. In this case, the dresser 6 performs a combined motion consisting of tilting with respect to the X-axis and tilting with respect to the Y-axis about the bearing ball 42 acting as the center of rotation.

The error signals eα and eβ are subjected to a tilt control and attenuation processing in a PID+local phase-lead processing section 31-1 and are further passed through a notch filter 31-2 to remove vibrational components, and converted into voltage command signals Vα and Vβ. Then, in a coordinate converter 31-3, the voltage command signals Vα and Vβ are converted into control signals Vₓᵤ and V_{yu} output by the attitude controller for supply to a driver section 32.

The driver section 32 includes the electromagnetic coils 13a, 13b, 13c and 13d and drive circuits 24 for exciting these coils. The control signals Vₓᵤ and V_{yu} are supplied to the respective drive circuits 24, in which they are converted into excitation currents Iₓᵤ+, Iₓᵤ-, I_{yu}+ and I_{yu}- for displacing the armature 14 in any of the positive and negative directions of the X- and Y-axes shown in Fig. 3. The excitation currents Iₓᵤ+, Iₓᵤ-, I_{yu}+ and I_{yu}- are supplied to the electromagnetic coils 13a, 13b, 13c and 13d to control the attitude of the controlled object (dresser 6). In this case, the center of rotation (bearing ball 42) of the dresser 6 and the X- and Y-axes of the armature 14 shown in Fig. 3 are set apart from each other by a predetermined height (L). Therefore, when the armature 14 is displaced in the positive or negative direction of the X- or Y-axis shown in Fig. 3, the dresser body 9, that is, the dresser 6, can be tilted in the desired direction with respect to the horizontal plane about the bearing ball 42 as the center of rotation.

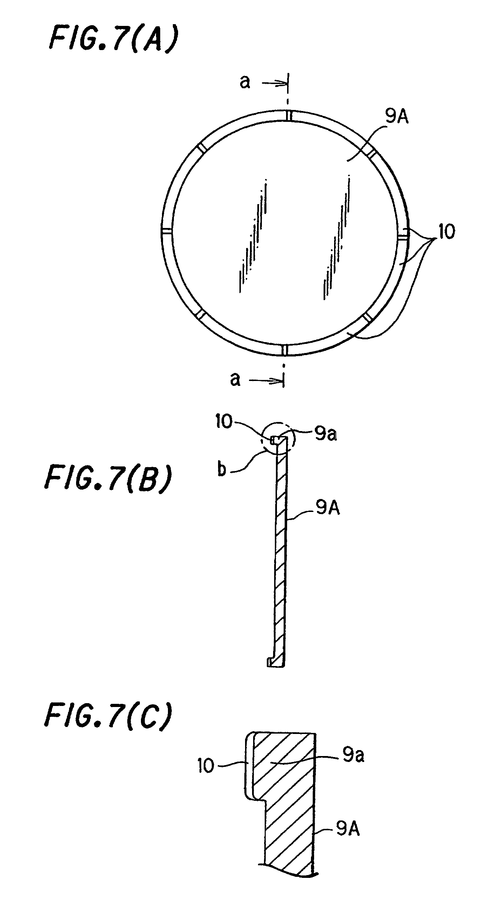

Fig. 7(a) - (c) show details of the structure of the dressing plate 9A, in which: Fig. 7(a) is a bottom view; Fig. 7(b) is a sectional view taken along the line a-a in Fig. 7(a); and Fig. 7(c) is an enlarged view of a portion b shown in Fig. 7(b). The dressing plate 9A has a disk-shaped configuration. An annular belt-shaped projecting portion 9a with a predetermined width is formed at the peripheral edge of the lower surface thereof to allow fine particles of diamond to be electrodeposited thereon. Thus, a diamond electrodeposited ring 10 is provided on the surface of the projecting portion 9a by electrodeposition of fine particles of diamond.

As is well known, in a polishing operation, a semiconductor wafer carried by a wafer carrier is pressed against the polishing cloth 2, while an abrasive liquid is supplied onto the polishing cloth. When the polishing operation is continued for a predetermined period of time, abrasive particles (grains) and substances removed from a wafer adhere to the polishing cloth 2 causing a deterioration in the surface of the polishing cloth 2. Therefore, a dressing operation for recovering the surface condition or polishing surface of the polishing cloth 2 is carried out by using the dressing apparatus 5 before, after or during polishing of a semiconductor wafer. More specifically, the turntable 1 and the dresser 6 are rotated, and a dressing liquid such as pure water is supplied from the dressing liquid supply nozzle 60 toward approximately the center of rotation of the polishing cloth 2. In this state, the surface of the diamond electrodeposited ring 10 is brought into contact with the polishing cloth surface to thereby shave the polishing cloth surface and effect dressing. The diamond electrodeposited ring 10 has a structure in which fine particles of diamond are deposited on the surface of the projecting portion 9a, and the diamond deposited portion is plated with nickel, thereby fixing the fine particles of diamond with the deposited nickel layer.

In this embodiment, the dimensions of the dresser 6 are, for example, as follows. The diameter of the dresser body 9 is 250 millimeters, and the diamond electrodeposited ring 10 having a width of 6 millimeters is formed on the peripheral edge of the lower surface of the dresser body 9. The diamond electrodeposited ring 10 is split into a plurality of portions (8 portions in the illustrated example). The diameter of the dresser body 9 is set to be larger than the diameter of a semiconductor wafer as an object to be polished so that when a semiconductor wafer is polished, the dressed surface of the polishing cloth includes sufficient margins for the surface of the semiconductor wafer to be polished in both radially inward and outward directions of the turntable 1. It should be noted that the diamond dresser having a diamond electrodeposited ring may be replaced with an SiC dresser using a ring having a plurality of SiC sectors. In this case, the SiC dresser has a structure similar to that shown in Figs. 7(a) - (c). The SiC dresser has a large number of pyramidal projections of several tens of micrometers in size on the surface thereof.

During the above-described dressing process, the attitude of the dresser body 9 is controlled by the attitude controller 11. In this case, as has been stated above, the tilt of the dresser body 9 is detected by processing the outputs of the displacement sensors 15 (15a₁, 15a₂; 15b₁, 15b₂; 15c₁, 15c₂; and 15d₁, 15d₂), and the title of the dresser body 9 is rectified to cause the dresser body 9 to lie in a horizontal plane. Alternatively, the dresser body 9 is controlled to a desired angle in a desired direction with respect to the horizontal plane. As such, a strictly parallel relation between the dressing surface of the dresser body 9, that is, the lower surface of the diamond electrodeposited ring 10, and the upper surface of the polishing cloth 2, that is, the polishing surface can be maintained during the dressing operation.

According to this embodiment, a force for pressing the dresser body 9 against the polishing surface of the turntable 1 is obtained by transmitting the pressing force of the air cylinder 22 directly to the dresser 6. To control the attitude of the dresser 6, the state of the polishing surface on the upper side of the turntable 1, including undulations or the like, are previously measured and input to the controller so that an optimum attitude of the dresser 6 is obtained on the basis of the data input in advance. Thus, optimum attitude of the dresser 6 is effected by the attitude controller 11 on the basis of the detection of the attitude by means of the displacement sensors 15.

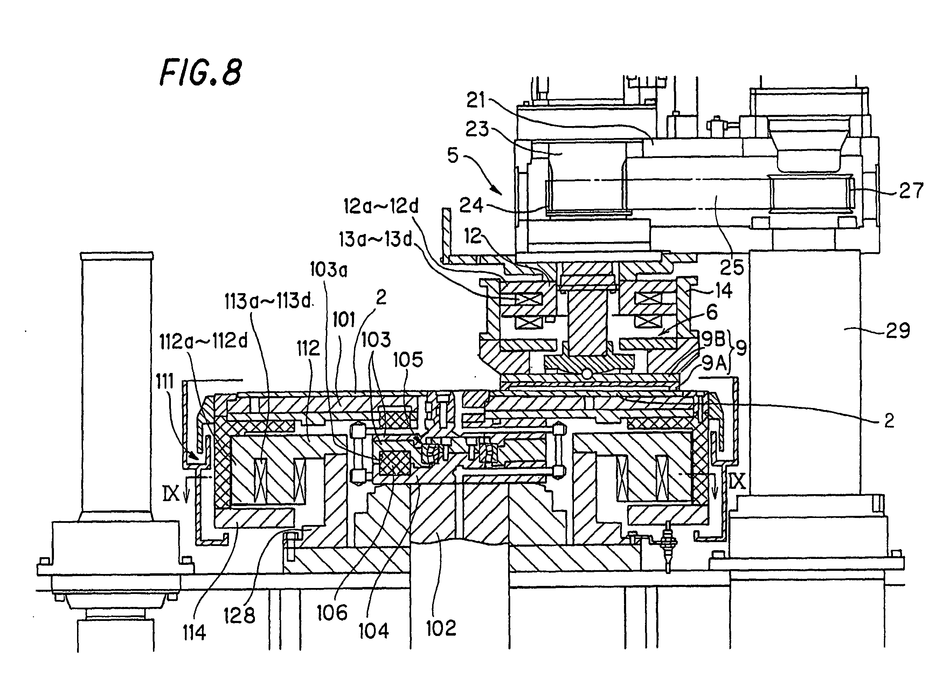

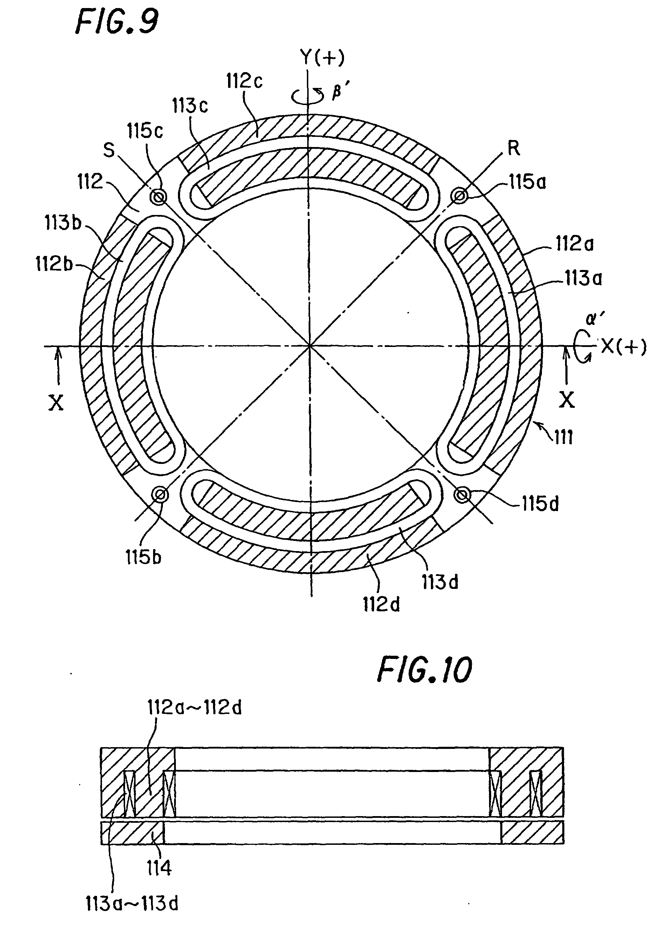

With reference to Figs. 8 to 11, there is shown a polishing apparatus provided with a dressing apparatus in accordance with a second embodiment of this invention. Fig. 8 is a vertical sectional view of the polishing apparatus. Fig. 9 is a sectional view taken along the line IX-IX in Fig. 8. Fig. 10 is a sectional view taken along the line X-X in Fig. 9.

In the second embodiment, the arrangement of a dresser unit including a dresser 6 and an attitude controller 11 is the same as in the first embodiment. The second embodiment differs from the first embodiment in the arrangement of a turntable. That is, in the second embodiment, the turntable is provided with an attitude controller.

As shown in Fig. 8, a turntable 101 having a polishing cloth 2 on the upper surface thereof and a rotating shaft 102 of a motor (not shown) are coupled to each other through upper and lower coupling members 103 and 104. The lower coupling member 104 is secured to the upper end of the rotating shaft 102 of the motor. The upper coupling member 103 is secured to the lower surface of the turntable 101. A self-aligning roller bearing 105 is disposed between the lower coupling member 104 and the upper coupling member 103 to allow the turntable 101 and the upper coupling member 103 to tilt in any direction with respect to the lower coupling member 104 about the self-aligning roller bearing 105 which acts as the center of rotation. The lower coupling member 104 is provided with a short column-shaped pin 106 that is engaged with an engagement hole 103a provided in the upper coupling member 103 to allow the turntable 101 to rotate. It should be noted that a predetermined clearance is formed between the engagement hole 103a and the pin 106 to enable tilting of the turntable 101.

In this embodiment, an attitude controller 111 for controlling the attitude of the turntable 101 is provided. The attitude controller 111 includes an electromagnetic core 112 secured to a frame 28. The electromagnetic core 112 is provided with four magnetic poles 112a, 112b, 112c and 112d. Four electromagnetic coils 113a, 113b, 113c and 113d are wound on the magnetic poles 112a to 112d, respectively. The attitude controller 111 further includes an annular disk-shaped armature 114 facing the magnetic poles 112a to 112d across a gap. The armature 114 is secured to the turntable 101.

As shown in Fig. 10, the magnetic poles 112a to 112d each have an inverted U-shaped sectional configuration. The inner portions of the inverted U-shaped magnetic poles 112a to 112d are wound with the electromagnetic coils 113a to 113d, respectively. The magnetic poles 112a to 112d and the armature 114 are formed from a magnetic material, e.g. a permalloy. As shown in Fig. 9, the electromagnetic coil 113a is placed at a position in positive alignment with the X-axis. The electromagnetic coil 113b is placed at a position in negative alignment with the X-axis. The electromagnetic coil 113c is placed at a position in positive alignment with the Y-axis. The electromagnetic coil 113d is placed at a position in negative alignment with the Y-axis. Four displacement sensors 115a, 115b, 115c and 115d are placed on two axes R and S tilted at 45 degrees with respect to the X- and Y-axes.

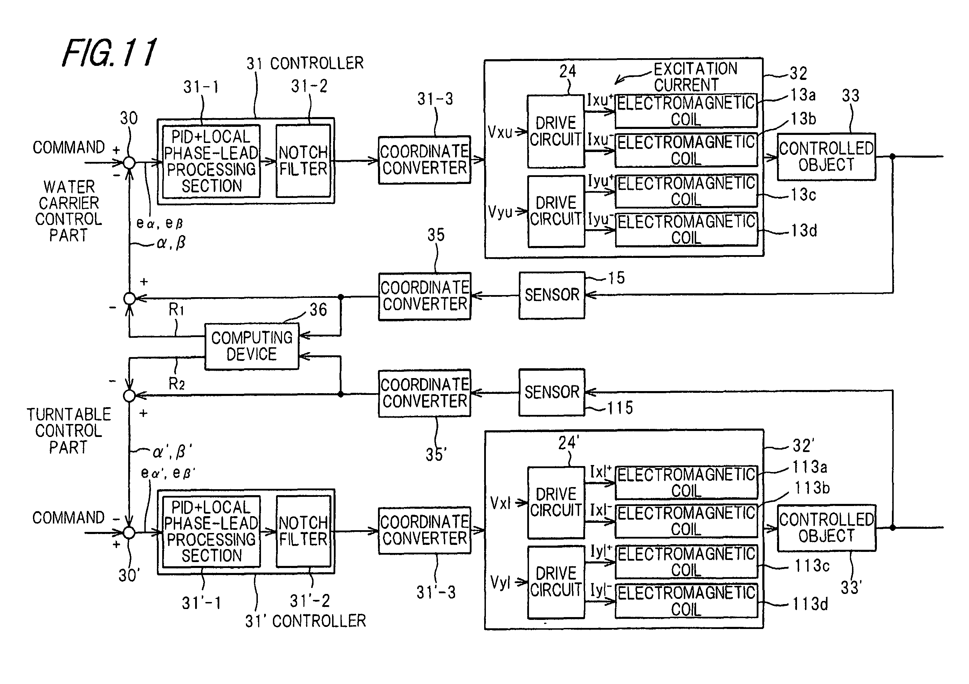

Fig. 11 is a block diagram showing the functional arrangement of a control part for controlling the attitude controller 111. As shown in the figure, the turntable control part and the dresser control part each have an arrangement similar to that of the control part shown in Fig. 5. The arrangement shown in Fig. 11 is additionally provided with a computing device for precisely detecting relative positions of the dresser and the turntable on the basis of signals input thereto from the dresser control part and the turntable control part.

As shown in fig. 11, the dresser control part has a subtracter 30 and a controller 31. The subtracter 30 is supplied with desired values for the attitude of the dresser, and values α and β of displacement of the controlled object that are detected by sensors 15 and converted in a coordinate converter 35 and further corrected by a computing device 36 on the basis of information concerning the tilt of the turntable. Differences between the desired values and the displacement values α and β derived from the subtracter 30 are input to the controller 31 as error signals eα and eβ.

The turntable control part has a subtracter 30' and a controller 31'. The subtracter 30' is supplied with desired values for the attitude of the turntable and values α' and β' of displacement of the controlled object that are detected by sensors 115 (displacement sensors 115a, 115b, 115c and 115d) and converted in a coordinate converter 35', and further modified by the computing device 36 on the basis of information concerning the tilt of the dresser. Differences between the desired values and the displacement values α' and β' derived from the subtracter 30' are input to the controller 31' as error signals eα' and eβ'.

The computing device 36 computes relative errors from information concerning the tilt of the dresser and information concerning the tilt of the turntable to generate rectified displacement values α, β, α' and β', thereby allowing control to be effected with a high degree of accuracy. Normally, the degree of accuracy can be raised by correcting the desired position of the dresser with reference to the tilt of the turntable. Thus, the feedback R1 to the dresser may be omitted. Further, the computing device may be omitted. As shown in Fig. 9, α' and β' indicate a tilt with respect to an X-axis and a tilt with respect to a Y-axis, respectively. In this case, the turntable 101 performs a combined motion consisting of tilting with respect to the X-axis and tilting with respect to the Y-axis about the self-aligning roller bearing 105 which acts as the center of rotation.

The error signals eα' and eβ' are subjected to tilt control and attenuation processing in a PID+local phase-lead processing section 31'-1 and further passed through a notch filter 31'-2 to remove vibrational components, to thereby be converted into voltage command signals Vα' and Vβ'. Then, in a coordinate converter 31'-3, the voltage command signals Vα' and Vβ' are converted into control signals Vₓ₁ and V_{y1} for the attitude controller, which are supplied to a driver section 32'.

The driver section 32' includes the electromagnetic coils 113a, 113b, 113c and 113d and drive circuits 24' for exciting these coils. The control signals Vₓ₁ and V_{y1} are supplied to the respective drive circuits 24', in which they are converted into excitation currents Iₓ₁+, Iₓ₁-, I_{y1}+ and I_{y1}- for displacing the armature 114 in any of the positive and negative directions of the X- and Y-axes shown in Fig. 8. The excitation currents Iₓ₁+, Iₓ₁-, I_{y1}+ and I_{y1}- are supplied to the electromagnetic coils 113a, 113b, 113c and 113d to control the attitude of the controlled object (turntable 101) 33'.

According to the embodiment shown in Figs. 8 to 11, it is possible to control the attitude of the turntable 101 in addition to the attitude of the dresser 6. Therefore, it is possible to carry out dressing while maintaining the dressing surface of the dresser body 9 and the polishing surface on the turntable 101 in an optimum state.

As has been stated above, according to the present invention, the attitude of the dresser is controlled by utilizing electromagnetic forces, thereby allowing dressing to be carried out while maintaining an optimum distribution of surface pressure applied to the polishing surface from the dresser. Accordingly, it is possible to obtain a polishing surface having a high degree of flatness.

Further, according to the present invention, a pressing force under which the dressing surface of the dresser body is pressed against the polishing surface of the turntable is obtained by transmitting the pressing force of the air cylinder directly to the dresser. Only the control of the tilt of the dresser is effected by the attitude controller by utilising electromagnetic forces. Therefore, the attitude controller is able to be compact in size and simple in structure.

## Claims

1. A dressing apparatus (5) for dressing a polishing surface on a turntable (1) that comes into sliding contact with an object to be polished, said dressing apparatus (5) comprising:
a dresser body (9) for dressing said polishing surface by contacting said polishing surface; and
pressing means for pressing said dresser body (9) against the polishing surface of said turntable (1), **characterised by**
attitude control means for controlling an attitude or orientation of said dresser body (9) by means of an electromagnetic force.

2. A dressing apparatus (5) according to claim 1, wherein said dresser body (9) has a dressing surface formed on a lower side thereof and adapted to be engaged with said polishing surface and said attitude control means is adapted to control a tilt angle of said dressing surface with respect to said polishing surface in a running direction of said turntable (1).

3. A dressing apparatus according to Claim 1 or 2, wherein said pressing means is a drive shaft (7) for drivingly rotating said dresser body (9) and said dressing apparatus (5) includes a universal joint connecting said drive shaft and said dresser body (9) in such a manner that said dresser body (9) can tilt relative to said drive shaft (7).

4. A dressing apparatus according to Claim 3, wherein said dressing apparatus (5) includes a frame for supporting said drive shaft in such a manner that the drive shaft can rotate about its axis, and said attitude controller (11) comprises:
an electromagnetic device fixedly provided on said frame, and
armature means fixedly provided on said dresser body (9) and adapted to be moved by means of an electromagnetic force generated by said electromagnetic device.

5. A dressing apparatus in accordance with any one of the preceding Claims, wherein said attitude controller (11) includes sensor means for sensing the attitude or orientation of said dresser body (9) so that said attitude controller (11) is adapted to control the attitude of said dresser body (9) in response to the sensed attitude or orientation.

6. A polishing apparatus including a turntable (1) having a polishing surface that comes into sliding contact with an object to be polished, and a dressing apparatus (5) for dressing said polishing surface as set forth in claims 1 to 5.

7. A polishing apparatus according to claim 6, wherein said polishing apparatus further includes a turntable drive shaft for drivingly rotating said turntable (1) and a joint for connecting said drive shaft (7) to said turntable (1) in such a manner that said turntable (1) can be rotated while being allowed to tilt relative to said turntable drive shaft, a turntable attitude controller (11) for controllably tilting said turntable about said joint by means of an electromagnetic force.

8. A polishing apparatus according to Claim 7, wherein said polishing apparatus includes a stationary frame, and said turntable attitude controller (11) comprises:
an electromagnetic device fixedly provided on said stationary frame of said polishing apparatus, and
armature means fixedly provided on said turntable (1) and adapted to be moved by means of an electromagnetic force generated by said electromagnetic device.

## Patentansprüche

1. Aufbereitungsvorrichtung bzw. Abrichtwerkzeug (5) zum Aufbereiten bzw. Abrichten einer Polieroberfläche an einem Drehtisch (1), der in Gleitkontakt mit einem zu polierenden Gegenstand kommt, wobei die Aufbereitungsvorrichtung (5) Folgendes aufweist:
einen Aufbereitungs- bzw. Abrichtkörper (9) zum Aufbereiten bzw. Abrichten der Polieroberfläche durch Kontakt mit der Polieroberfläche; und
Andrückmittel zum Andrücken des Aufbereitungskörpers (9) gegen die Polieroberfläche des Drehtischs (1), **gekennzeichnet durch**:
Lagesteuermittel zum Steuern einer Lage oder Ausrichtung des Aufbereitungskörpers (9) mittels einer elektromagnetischen Kraft.

2. Aufbereitungsvorrichtung (5) nach Anspruch 1, wobei der Aufbereitungskörper (9) eine Aufbereitungsoberfläche aufweist, die an einer Unterseite davon ausgebildet ist und in der Lage ist, mit der Polieroberfläche in Eingriff zu kommen, und wobei die Lagesteuermittel in der Lage sind, einen Kippwinkel der Aufbereitungsoberfläche bezüglich der Polieroberfläche in eine Laufrichtung des Drehtischs (1) zu steuern.

3. Aufbereitungsvorrichtung nach Anspruch 1 oder 2, wobei die Andrückmittel eine Antriebswelle (7) sind, zum antriebsmäßigen Drehen des Aufbereitungskörpers (9), und wobei die Aufbereitungsvorrichtung (5) ein Universalgelenk umfasst, das die Antriebswelle und den Aufbereitungskörper (9) in einer solchen Art und Weise verbindet, dass der Aufbereitungskörper (9) sich relativ zur Antriebswelle (7) neigen bzw. verkippen kann.

4. Aufbereitungsvorrichtung nach Anspruch 3, wobei die Aufbereitungsvorrichtung (5) einen Rahmen aufweist zum Tragen der Antriebswelle in einer solchen Art und Weise, dass sich die Antriebswelle um ihre Achse drehen kann und wobei die Lagesteuerung (11) Folgendes aufweist:
eine elektromagnetische Einrichtung, die fest an dem Rahmen vorgesehen ist, und
Ankermittel, die fest an dem Aufbereitungskörper vorgesehen sind, und
die in der Lage sind mittels einer elektromagnetischen Kraft bewegt zu werden, die durch die elektromagnetische Einrichtung erzeugt wird.

5. Aufbereitungsvorrichtung nach einem der vorhergehenden Ansprüche, wobei die Lagesteuerung (11) Sensormittel umfasst zum Abfühlen der Lage oder Ausrichtung des Aufbereitungskörpers (9), so dass die Lagesteuerung (11) in der Lage ist, die Lage des Aufbereitungskörpers (9) ansprechend auf die abgefühlte Lage oder Ausrichtung zu steuern.

6. Eine Poliervorrichtung mit einem Drehtisch (11) mit einer Polieroberfläche, die in Gleitkontakt mit einem zu polierenden Gegenstand kommt, und einer Aufbereitungs- bzw. Abrichtvorrichtung (5) zum Aufbereiten der Polieroberfläche nach einem der Ansprüche (1) bis (5).

7. Poliervorrichtung nach Anspruch 6, wobei die Poliervorrichtung ferner Folgendes aufweist: eine Drehtischantriebswelle zum antriebsmäßigen Drehen des Drehtischs (1), ein Gelenk zum Verbinden der Antriebswelle (7) mit dem Drehtisch (1) in einer solchen Art und Weise, das der Drehtisch (1) gedreht werden kann während ihm erlaubt wird, sich relativ zu der Drehtischantriebswelle zu kippen, und eine Drehtischlagesteuerung (11) zum steuerbaren Kippen des Drehtischs um das Gelenk mittels einer elektromagnetischen Kraft.

8. Poliervorrichtung nach Anspruch 7, wobei die Drehvorrichtung einen stationären Rahmen umfasst und wobei die Drehtischlagesteuerung (11) Folgendes aufweist:
eine elektromagnetische Einrichtung, die fest an dem stationären Rahmen der Poliervorrichtung vorgesehen ist, und
Ankermittel, die fest an dem Drehtisch (1) vorgesehen sind und die in der Lage sind mittels einer elektromagnetischen Kraft bewegt zu werden, die durch die elektromagnetische Einrichtung erzeugt wird.

## Revendications

1. Dispositif de dressage (5) pour dresser une surface de polissage sur un plateau tournant (1) qui vient en contact glissant avec un objet devant être poli, ledit dispositif de dressage (5) comprenant :
un corps de dressage (9) pour dresser ladite surface de polissage par le contact avec ladite surface de polissage ; et
des moyens de pressage pour presser ledit corps de dressage (9) contre la surface de polissage dudit plateau tournant (1) ; **caractérisé par**
des moyens de contrôle de position qui permettent de contrôler une position ou une orientation dudit corps de dressage (9) au moyen d'une force électromagnétique.

2. Dispositif de dressage (5) selon la revendication 1, dans lequel ledit corps de dressage (9) a une surface de dressage qui est formée sur un côté inférieur de celui-ci et qui est adaptée pour se mettre en prise avec ladite surface de polissage, et lesdits moyens de contrôle de position sont adaptés pour contrôler un angle d'inclinaison de ladite surface de dressage par rapport à ladite surface de polissage dans une direction de marche dudit plateau tournant (1).

3. Dispositif de repassage (5) selon la revendication 1 ou 2, dans lequel lesdits moyens de dressage sont un arbre d'entraînement (7) pour entraîner ledit corps de dressage (9) à tourner, et ledit dispositif de dressage (5) comprend un raccord universel qui raccorde ledit arbre d'entraînement audit corps de dressage (9) de telle manière que ledit corps de dressage (9) peut s'incliner relativement audit arbre d'entraînement (7).

4. Dispositif de dressage (5) selon la revendication 3, dans lequel ledit dispositif de dressage (5) comprend un bâti pour supporter ledit arbre d'entraînement de telle manière que l'arbre d'entraînement peut tourner autour de son axe, et ledit dispositif de contrôle de position (11) comprend :
un dispositif électromagnétique qui est monté fixement sur ledit bâti, et
des moyens formant induit qui sont montés fixement sur ledit corps de dressage (9) et qui sont adaptés pour se déplacer au moyen d'une force électromagnétique produite par ledit dispositif électromagnétique.

5. Dispositif de dressage (5) selon l'une quelconque des revendications précédentes, dans lequel ledit dispositif de contrôle de position (11) comprend des moyens de détection pour détecter la position ou l'orientation dudit corps de dressage (9) de sorte que ledit dispositif de contrôle de position (11) est adapté pour contrôler la position dudit corps de dressage (9) en réponse à la position ou à l'orientation détectée.

6. Appareil de polissage comprenant un plateau tournant (1) ayant une surface de polissage qui vient en contact glissant avec un objet qui doit être poli, et un dispositif de dressage (5) pour dresser ladite surface de polissage, comme ceci est défini dans les revendications 1 à 5.

7. Appareil de polissage selon la revendication 6, dans lequel ledit appareil de polissage comprend en outre un arbre d'entraînement de plateau tournant pour entraîner ledit plateau tournant (1) en rotation, et un raccord pour raccorder ledit arbre d'entraînement (7) audit plateau tournant (1) de telle manière que ledit plateau tournant (1) peut tourner et peut s'incliner en même temps relativement audit arbre d'entraînement de plateau tournant, un dispositif de contrôle de position de plateau tournant (11) pour permettre audit plateau tournant de s'incliner de façon contrôlée autour dudit raccord au moyen d'une force électromagnétique.

8. Appareil de polissage selon la revendication 7, dans lequel ledit appareil de polissage comprend un bâti fixe, et ledit dispositif de contrôle de position de plateau tournant (11) comprend :
un dispositif électromagnétique monté fixement sur ledit bâti fixe dudit appareil de polissage, et
des moyens formant induit qui sont montés fixement sur ledit plateau tournant (1) et qui sont adaptés pour se déplacer au moyen d'une force électromagnétique produite par ledit dispositif électromagnétique.
